# EUROPEAN PATENT SPECIFICATION

(11) **EP 1 776 001 B1**
(45) Date of publication and mention of the grant of the patent: **09.03.2011**
(21) Application number: 07100813.0
(22) Date of filing: 05.01.1998
(51) Int. Cl.: H05K 1/14, H05K 3/36, H01L 23/12

(54) **Printed wiring board and manufacturing method therefor**
Gedruckte Leiterplatte und Verfahren zu deren Herstellung
Panneau à circuit imprimé et son procédé de fabrication

(30) Priority: 30.01.1997 JP 3303397; 30.01.1997 JP 3303497; 25.11.1997 JP 34072397
(43) Date of publication of application: 18.04.2007
(62) Divisional of application: 98900160.7
(73) Proprietor: IBIDEN CO., LTD., Ogaki-shi, Gifu 503-0917 (JP)
(72) Inventor: Ishida, Naoto c/o Ibiden Co., Ltd., Gifu-ken 503 (JP); Asano, Kouji c/o Ibiden Co., Ltd., Gifu-ken 503 (JP)
(74) Representative: Vossius & Partner

(56) References cited:
- AT-B- 401 704
- FR-A- 2 571 547
- JP-A- 6 045 722
- JP-A- 63 229 842
- PATENT ABSTRACTS OF JAPAN vol. 014, no. 391 (E-0968), 23 August 1990 (1990-08-23) & JP 02 144945 A (SUMITOMO BAKELITE CO LTD), 4 June 1990 (1990-06-04)
- PATENT ABSTRACTS OF JAPAN vol. 014, no. 557 (E-1011), 11 December 1990 (1990-12-11) & JP 02 239577 A (NEC CORP), 21 September 1990 (1990-09-21)

## Description

### Technical field

The present invention relates to a printed wiring board and its manufacturing method, and particularly relates to joining of the printed wiring board and a mother board.

### Background art

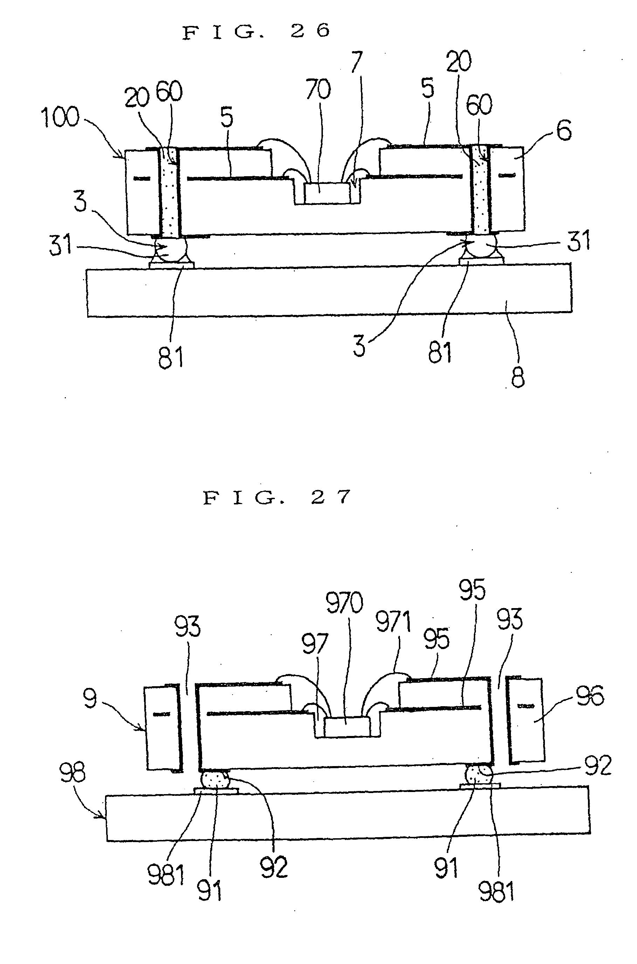

For example, as shown in FIG. 27, there is conventionally a printed wiring board having a circuit substrate 96 having a mounting portion 97 for mounting an electronic part 970 thereto, a conductor circuit 95 arranged on a surface of the circuit substrate 96 and also arranged within this circuit substrate 96, and a through hole 93 extending through the circuit substrate 96.

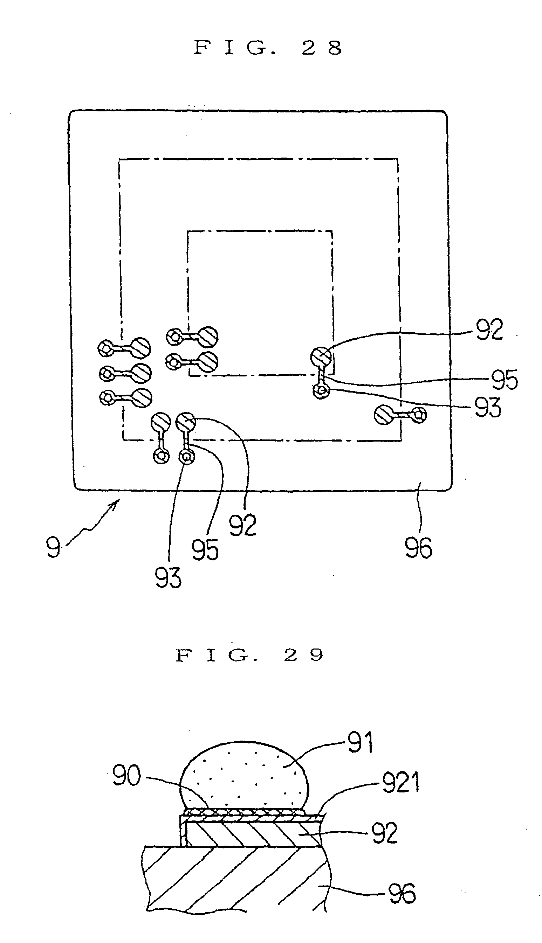

The electronic part 970 is electrically connected to the conductor circuit 95 by a bonding wire 971. As shown in FIGS. 27 and 28, a pad 92 for mounting a ball 1 thereto is arranged at an end tip of the conductor circuit 95 on a rear face side of the circuit substrate 96. A soldering ball 91 is joined to a surface of this pad 92.

The above conventional printed wiring board 9 is joined to an opposite party pad 981 arranged on the surface of a mother board 98 by heating and melting the above soldering ball 91.

The printed wiring board fulfills a function from the above structure for transmitting electric information of the electric part to a partner member such as the mother board, etc.

However, the above conventional printed wiring board has the following problems. In particular, as shown in FIGS. 27 and 28, the printed wiring board 9 is fixedly joined onto the mother board 98 by the soldering ball 91. Therefore, the pad 92 for mounting the soldering ball must be arranged in the printed-wiring board 9.

Furthermore, it is necessary to arrange the conductor circuit 95 between the pad 92 for mounting the ball and the through hole 93 and electrically connecting the pad 92 and the through hole 92. Therefore, as shown in FIG. 28, the rear face side of the circuit substrate 96 is occupied by the pad 92 for mounting the ball and the conductor circuit 95 connected to the through hole 93 as well as the through hole 93. As a result, it is difficult to secure a sufficient space for arranging another conductor circuit on the rear face side of the circuit substrate 96 so that high density wiring is prevented.

When the soldering ball 91 is joined to the opposite party pad 981, it is difficult to control a melting state of the soldering ball 91. In particular, the soldering ball 91 is melted and joined by heating this soldering ball 91 to the opposite party pad 981 on the mother board 98. At this time, the melting state of the soldering ball 91 is different according to the elements such as heating temperature, applied pressure, soldering composition, etc. Therefore, as shown in FIG. 27, there is a case in which a melting degree of the soldering ball 91 on one side (e.g., a right-hand side of FIG. 27) of the printed wiring board 9 is increased and the melting degree of the soldering ball 91 on the other side (e.g., a left-hand side of FIG. 27) is decreased. In this case, the printed wiring board 9 is joined slantingly to the mother board 98. Accordingly, it is difficult to join the conventional printed wiring board 9 to the mother board 98 in parallel with this mother board 98.

In addition, as shown in FIG. 29, the pad 92 for mounting the ball and joining the soldering ball 91 is generally covered with a gold plating film 921. A gold component of the gold plating film 921 permeates the interior of the soldering ball 91 in heating and melting the soldering ball 91, and forms an intermediate layer 90 between the metallic plating film 921 and the soldering ball 91.

This intermediate layer 90 has a property which deteriorates by heat. Therefore, when the intermediate layer 90 is formed, joining strength of the pad 92 for mounting the ball and the soldering ball 91 is reduced from 1. 0 to 1. 4 kg/cm².

Furthermore, the intermediate layer 90 increases in thickness as the gold plating film 921 covering the pad 92 for mounting ball increases in thickness. Therefore, When the thickness of the gold plating film 921 is increased, the joining strength of the pad 92 for mounting the ball and the soldering ball 91 is further reduced. Accordingly, there is a case in which the joining strength is reduced to a joining strength equal to or smaller than 1.0 kg/cm².

Relevant prior art is disclosed in JP-A-02144945 and FR-A-2 571 547.

With consideration to such conventional problems, the present invention provides a printed wiring board able to perform high density wiring on a substrate surface and be joined to a partner member in parallel with this partner member which has an excellent joining strength, and also provides a manufacturing method for the printed wiring board.

### Disclosure of the Invention

The present invention resides in a printed wiring board having a circuit substrate having a conductor circuit and a through hole, and a joining ball as defined in claim 1.

It is most noticeable in the present invention that the joining ball having the joining head portion is joined to the through hole and the bottom portion of the joining ball is joined to the through hole by the conductive material filling the interior of the through hole.

The above joining ball has the joining head portion for joining the joining ball to the opposite party pad and also has the bottom portion facing the opening portion of the through hole. The joining head portion is a portion greater than a diameter of the opening portion of the through hole and projecting from the through hole. The bottom portion is a portion facing the opening portion and joined to the through hole by the conductive material.

An operation and effects of the present invention will be explained.

In the printed wiring board of the present invention, the joining ball is joined to the through hole. The joining ball has the joining head portion for joining the joining ball to the opposite party pad. Therefore, the through hole and the opposite party pad can be electrically connected to each other by the joining ball by joining the joining head portion to the opposite party pad.

Further, the joining ball is joined to the opening portion of the through hole. Therefore, the through hole and the opposite party pad can be electrically connected to each other in a facing state. Accordingly, it is unnecessary to arrange a pad for mounting a soldering ball in addition to the through hole as in the conventional case.

It is also unnecessary to form a conductor circuit for connecting the through hole and the pad for mounting the ball as in the conventional case.

Therefore, a surplus space is formed on a surface of the circuit substrate in a portion except for the opening portion of the through hole. Accordingly, many other conductor circuits can be formed in this space so that a high density wiring structure can be realized on the substrate surface.

The joining ball is manufactured by using a material unmelted at the heating temperature in joining the joining ball to the opposite party pad. Therefore, a constant height of the joining ball is maintained without melting deformation in the above joining. Accordingly, the joining ball functions as a strut of the printed wiring board at the joining time.

The joining head portion of such a joining ball functioning as a strut is greater than the opening portion of the through hole. Therefore, when the joining ball is joined to the through hole as in the conventional example, the joining head portion is engaged with the opening portion of the through hole and does not enter the interior of the through hole. Accordingly, the joining head portion can be projected by the same height from a surface of the circuit substrate.

Therefore, when the joininghead portion and the opposite party pad are joined to each other, the distance between the printed wiring board and a partner member such as a mother board having the above opposite party pad, etc. is constantly secured by the above joining head portion. Accordingly, the printed wiring board can be joined to the partner member in a parallel arranging state.

Since no joining ball is melted and deformed at the heating temperature in the joining, it is not necessary to control a melting state of the conductive material for joining. Accordingly, the joining ball and the opposite party pad can be joined to each other easily.

In the present invention, the joining ball is arranged in the opening portion of the through hole, and the joining ball and the through hole are joined to each other by the conductive material. Further, since the printed wiring board of the present invention has no structure for joining a soldering ball to the pad for mounting the ball as in the conventional example, there is no fear that an intermediate layer causing a reduction in joining strength is formed between the soldering ball and the pad for mounting the ball. Accordingly, the joining ball can be strongly fixed to the through hole.

It is preferable to cover the joining head portion of the above joining ball with the conductive material as described in claim 2.

In this case, when the joining head portion is arranged on the opposite party pad on the mother board and is heated, the conductive material covering a surface of the joining head portion is melted so that the joining head portion and the opposite party pad are easily joined to each other. Accordingly, the joining head portion and the opposite party pad can be reliably joined to each other so that the printed wiring board can be easily mounted to the partner member, etc.

As described in claim 3, the above joining head portion is preferably set to a spherical body. In this case, the joining head portion of the joining ball can be stably joined to the opposite party pad on the mother board.

The bottom portion of the joining ball may also be constructed by a flat face, one portion of a spherical surface or a convex shape. The bottom portion is preferably constructed by a flat face in view of easiness of mounting.

For example, there is a manufacturing method of the printed wiring board as described in claim 6 as a method for manufacturing the printed wiring board having the above joining ball.

In the present invention, the joining ball having the joining head portion is arranged in the opening portion of the through hole and is joined to the through hole by filling the interior of the through hole with the conductive material. Therefore, in accordance with the manufacturing method of the present invention, it is possible to obtain a printed wiring board for electrically connecting the through hole and the opposite party pad to each other from the joining ball.

Therefore, it is unnecessary to arrange the pad for mounting the ball, etc. as in the conventional case. Accordingly, another conductor circuit can be further formed in a surplus space formed on a surface of the circuit substrate so that high density wiring can be performed.

The joining ball is manufactured by using an unmelted material in joining the joining ball to the opposite party pad. Therefore, it is possible to obtain a printed wiring board which can be joined to a partner member, etc. in parallel with this partner member. Further, since the bottom portion of the joining ball is opposed to the opening portion of the through hole and the joining ball is joined to the through hole by the conductive material, joining strength to the opposite party pad is high.

The joining head portion of the above joining ball is covered in advance with the conductive material before the joining head portion is arranged in the through hole. In this case, the printed wiring board can be reliably and easily mounted to the partner member.

As described in claim 8, the process for arranging the above joining ball and the process for filling the interior of the through hole with the conductive material are preferably performed in a state in which the joining head portion of the above joining ball is absorbed into a sucking port of a sucking device. In this case, the joining ball can be easily joined to the through hole.

The interior of the above through hole is filled with the conductive material from the opening portion on an arranging side of the joining ball, and is also filled with the conductive material from an opening portion on a side opposed to the opening portion on the arranging side of the joiningball. The interior of the through hole may be filled with the conductive material before the joining ball is arranged in the opening portion. Further, the interior of the through hole may be filled with the conductive material after the joining ball is arranged in the opening portion. For example, the interior of the through hole is filled with the conductive material by a method for printing the conductive material formed in a paste shape in the opening portion of the through hole and heating and reflowing this conductive material, a method for dipping the opening portion of the through hole into the melted conductive material, a flow soldering method, etc.

Similar to the invention relative to the above joining pin, it is also preferable to use a soldering material, epoxy resin impregnated with a silver filler, etc. as the above conductive material in the present invention relative to the joining ball. However, the present invention is not limited to this case.

The interior of the through hole is filled with the conductive material by using a method similar to that in the case of the invention relative to the above joining pin.

### Brief Description of the Drawings

FIG. 1 is a partial sectional view of a printed wiring board in example 1.
FIG. 2 is a cross-sectional view of a joining pin in example 1.
FIG. 3 is an explanatory view of a circuit substrate in example 1 in which plural resin substrates are laminated, pressed and attached to each other.
FIG. 4 is an explanatory view of the circuit substrate forming a through hole in example 1.
FIG. 5 is an explanatory view showing a method for inserting the joining pin into the through hole in example 1.
FIG. 6 is an explanatory view showing a state in which a soldering material is arranged on an opening portion of the through hole in example 1.
FIG. 7 is an explanatory view showing a state in which the through hole and the joining pin are soldered and joined to each other in example 1.
FIG. 8 is an explanatory view showing a state in which the printed wiring board is arranged on a mother board in example 1.
FIG. 9 is an explanatory view showing a state in which the printed wiring board is fixed to the mother board in example 1.
FIG. 10 is a plan explanatory view of the printed wiring board in example 1.
FIG. 11 is a sectional explanatory view of a printed wiring board in example 2.
FIG. 12 is a crass-sectional view seen from an arrow line C-C of FIG. 11.
FIG. 13 is a front view of a joining pin in example 3.
FIG. 14 is a sectional explanatory view of a through hole into which a leg portion of the joining pin is inserted in example 3.
FIG. 15 is a cross-sectional view seen from an arrow line A-A of FIG. 14 in example 3.
FIG. 16 is a cross-sectianal view seen from an arrow line B-B of FIG. 14 in example 3.
FIG. 17 is a cross-sectional view of a printed wiring board in example 4.
FIG. 18 is a partial sectional view of a printed wiring board in an embodiment 1.
FIG. 19 is a perspective view of a bottom portion of a joining ball in the embodiment 1.
FIG. 20 is an explanatory view showing a method for adsorbing the joining ball to a sucking device in the embodiment 1.
FIG. 21 is an explanatory view showing a method for mounting the joining ball to an opening portion of a through hole in the embodiment 1.
FIG. 22 is an explanatory view showing a method for filling the interior of the through hole with a soldering material in the embodiment 1.
FIG. 23 is an explanatory view showing a state in which the printed wiring board is arranged on a mother board in the embodiment 1.
FIG. 24 is an explanatory view showing a state in which the printed wiring board is fixed to the mother board in the embodiment 1.
FIG. 25 is a sectional explanatory view of a printed wiring board in an embodiment 2.
FIG. 26 is a sectional explanatory view of a printed wiring board in an embodiment 3.
FIG. 27 is a cross-sectional view of a printed wiring board in a conventional example.
FIG. 28 is a rear view of the printed wiring board in the conventional example.
FIG. 29 is an explanatory view showing a problem of a soldering ball in the conventional example.

### Explanation of reference numerals

- 1 ---: joining pin,
- 11 ---: joining head portion,
- 12 ---: leg portion,
- 111 ---: lower portion,
- 112 ---: groove,
- 121 ---: end tip portion,
- 122 ---: central portion,
- 125 ---: projecting portion,
- 2 ---: solder,
- 20 ---: soldering material,
- 100 ---: printed wiring board,
- 3 ---: joining ball,
- 31 ---: joining head portion,
- 32 ---: bottom portion,
- 39 ---: sucking device,
- 4---: heat radiating plate,
- 5---: conductor circuit,
- 6 ---: circuit substrate,
- 60 ---: through hole,
- 61 ---: resin substrate,
- 7---: mounting portion,
- 8 ---: mother board,
- 81 ---: opposite party pad.

### Example 1

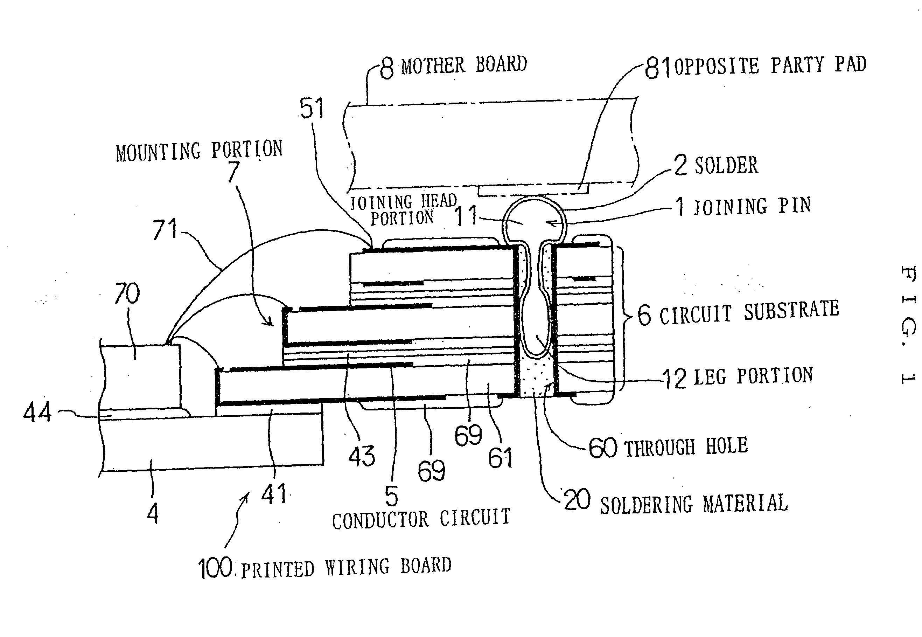

An example of a printed wiring board will be explained next by using FIGS. 1 to 10.

As shown in FIG. 1, the printed wiring board 100 in this example has a circuit substrate 6 having a conductor circuit 5 and a through hole 60, and a joining pin 1 inserted into the through hole 60.

The joining pin 1 is manufactured by using a material unmelted at a heating temperature when the joining pin 1 is soldered and joined to an opposite party pad 81 on a mother board 8. For example, the joining pin 1 is manufactured by using covar, phosphor bronze, etc. The joining pin 1 is constructed by a joining head portion 11 and a leg portion 12. The joining head portion 11 is greater than an opening diameter of the through hole 60 and forms a joining portion to the opposite party pad 81. The leg portion 12 has a size capable of inserting this leg portion 12 into the through hole 60. The leg portion 12 is inserted into the through hole 60 and is joined to a wall face of the through hole 60 by a soldering material 20.

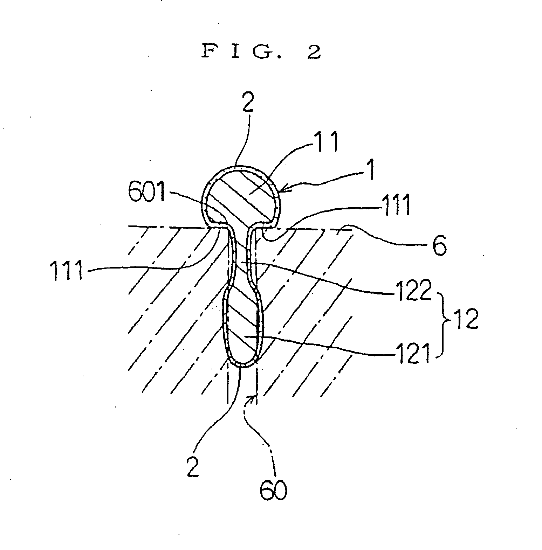

As shown in FIG. 2, the joining head portion 11 and the leg portion 12 of the joining pin 1 are covered with solder 2 which has a thickness of 10µm.

The joining head portion 11 is formed in the shape of a spherical body having 0. 75mm in diameter and 0. 6 mm in height. A lower portion 111 of the joining head portion 11, i.e., a portion opposed to the circuit substrate 6 in the joining head portion 11 forms a flat face. A central portion 122 of the leg portion 12 is smaller than an end tip portion 121 of the leg portion 12. A maximum diameter of the end tip portion 121 of the leg portion 12 is set to 0.35 mm. A minimum diameter of the central portion 122 of the leg portion 12 is set to 0. 2 mm. The leg portion 12 has a length of 1.6 mm.

An opening diameter of the through hole 60 is set to 0.32 mm. The through hole 60 has a length of 1.8 mm.

As shown in FIG. 1, the circuit substrate 6 is formed by laminating and press-attaching through an adhesive 43 plural resin substrates 61 to each other. A surface of each resin substrate 61 is covered with a resist film 69. A concave mounting portion 7 for mounting an electronic part 70 is formed in the circuit substrate 6. A bottom face of the mounting portion 7 is formed by a heat radiating plate 4 adhered to the circuit substrate 6. The heat radiating plate 4 is adhered to the circuit substrate 6 by an adhesive 41.

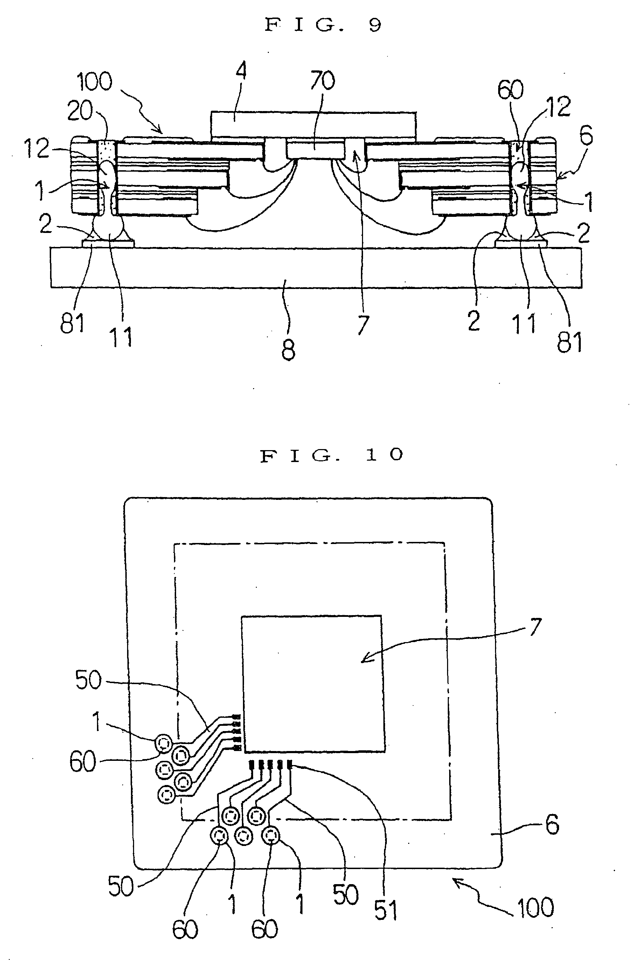

As shown in FIGS. 1 and 10, the conductor circuit 5 is arranged on a surface of the circuit substrate 6 and is also arranged within this circuit substrate 6. The conductor circuit 5 has a bonding pad portion 51 in the vicinity of the mounting portion 7. A bonding wire 71 connected to the electronic part 70 is joined to the bonding pad portion 51 by solder.

The printed wiring board 100 in this example is a substrate of a face-down type for mounting electronic parts. In this printed wiring board 100, the mounting portion 7 for mounting the electronic part 70 is located opposite to the mother board 8.

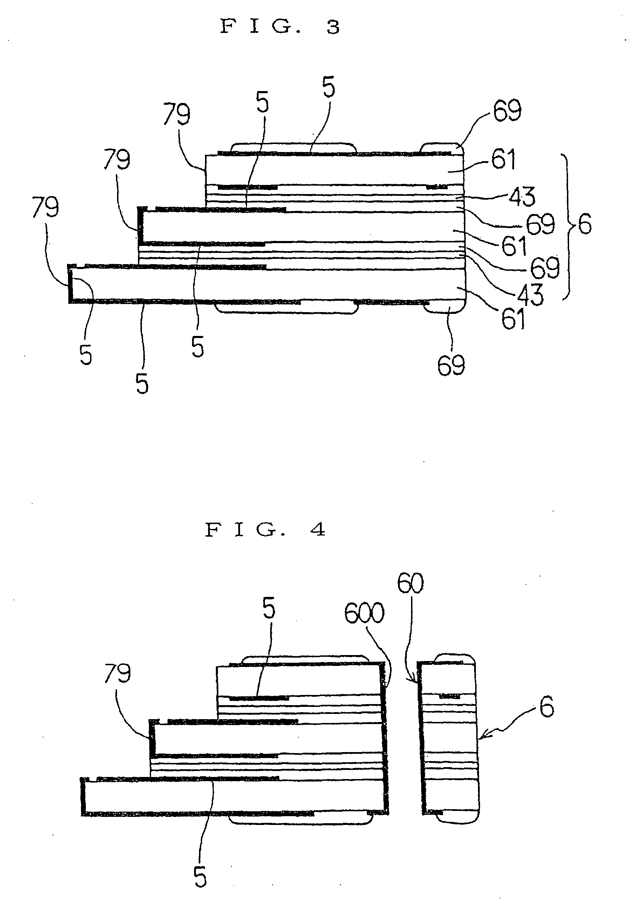

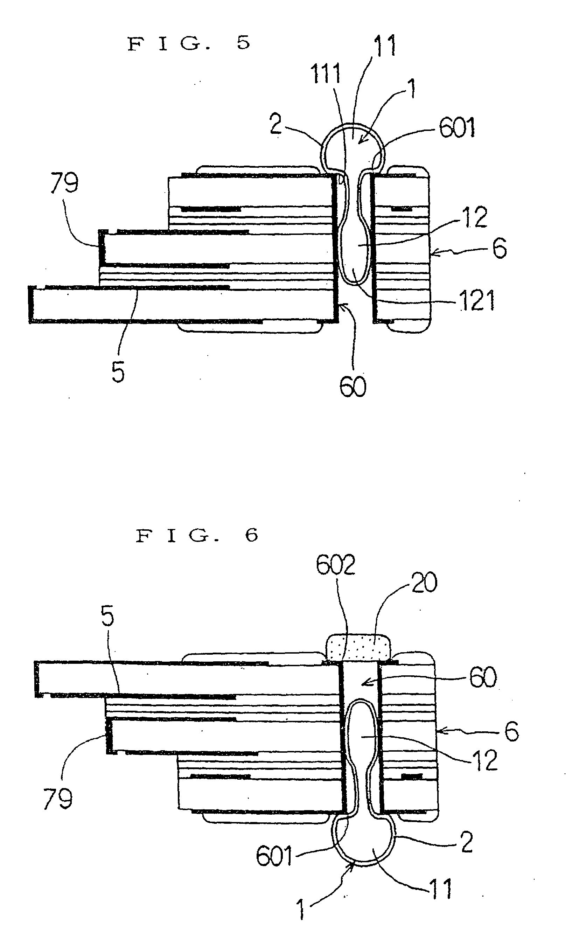

When the above printed wiring board is manufactured, the circuit substrate 6 is formed (FIG. 3), the joining pin 1 is inserted (FIG. 5), and the joining pin 1 is joined by the soldering material 20 (FIG. 6). A manufacturing method of the printed wiring board will be next explained in detail.

First, a copper foil is stuck to plural resin substrates and a through hole for forming a mounting port ion is bored. The copper foil is etched and a conductor circuit 5 is formed on a surface of each resin substrate 61 as shown in FIG. 3. Next, the conductor circuit 5 is also formed by a plating method in the inner wall of a through hole 79.

Next, the surface of each resin substrate 61 is covered with a resist film 69 except for the through hole 79 and a portion near a through hole forming portion. Following this, these resin substrates 61 are laminated and thermally press-attached to each other through an epoxy-system adhesive 43. Thus, a circuit substrate 6 having the multilayer conductor circuit 5 is obtained.

Next, as shown in FIG. 4, a through hole 60 extending through the circuit substrate 6 is bored. Following this, a metallic plating film 600 constructed by copper is formed on a wall face of the through hole 60 by an electroless plating method and an electrolytic plating method.

Next, as shown in FIG. 5, the above-mentioned joining pin 1 is press-fitted into the through hole 60 from one opening portion 601 of this through hole 60. A surface of the joining pin 1 is covered with solder 2. At this time, as shown in FIG. 2, since an end tip portion 121 of a leg portion 12 of the joining pin 1 is slightly greater than a diameter of the through hole 60, the joining pin 1 is inserted into the through hole 60 while the joining pin 1 presses against a wall face of the through hole 60. When the leg portion 12 is approximately inserted faultlessly into the through hole 60, a lower face 111 of a joining head portion 11 is engaged with an opening portion 601 of the through hole 60 so that the insertion of the joining pin 1 is stopped.

Next, as shown in FIG. 6, a soldering material 20 formed in a paste shape is arranged on an opening portion 602 of the through hole 60 on a side opposed to an inserting direction of the joining pin 1.

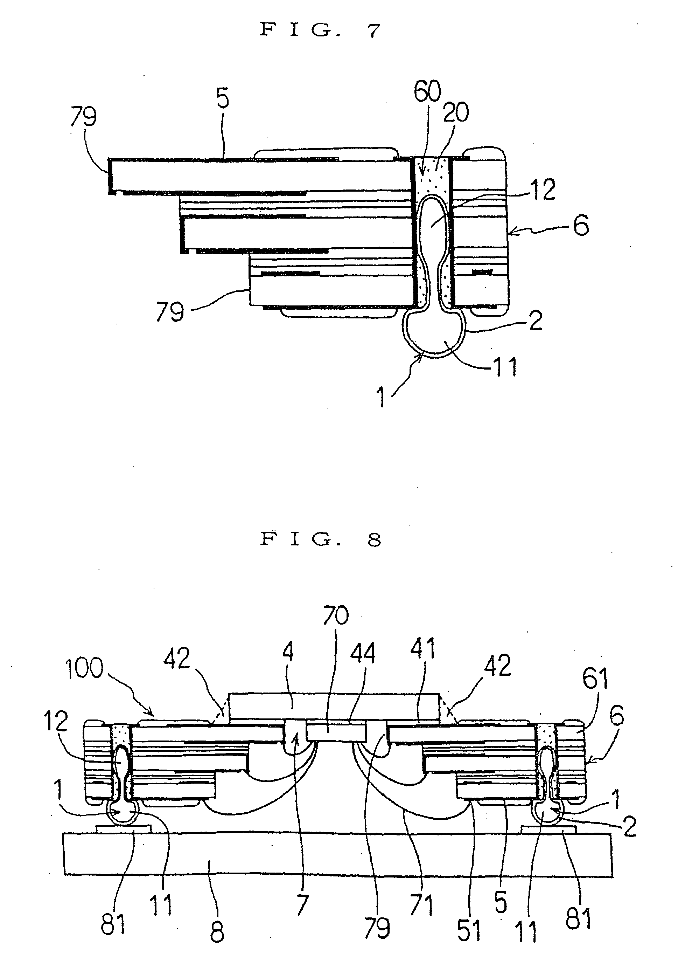

Next, as shown in FIG. 7, the soldering material 20 is melted by IR reflow, hot air reflow methods, etc. so that the interior of the through hole 60 is filled with the soldering material 20. Thus, the leg portion 12 of the joining pin 1 is joined to the through hole 60 by the soldering material 20.

Next, as shown in FIG. 8, a heat radiating plate 4 is adhered to the circuit substrate 6 by an adhesive 41 constructed of epoxy resin. The heat radiating plate 4 is adhered to the circuit substrate 6 so as to cover an opening portion of the through hole 79 formed in an outermost resin substrate 61. After the adhesion using the above adhesive 41, there is also a case in which a side face of the heat radiating plate 4 and a surface of the circuit substrate 6 are joined to each other by an adhesive 42 constructed of solder.

The above printed wiring board 100 is thus obtained.

As shown in FIG. 8, an electronic part 70 is adhered to a mounting portion 7 of the above printed wiring board 100 by an adhesive 44. The electronic part 70 is electrically connected to a bonding pad portion 51 of the conductor circuit 5 by a bonding wire 71. The electronic part 70 and the bonding wire 71 are sealed by resin.

Next, the joining pin 1 of the printed wiring board 100 is arranged on the surface of an opposite party pad 81 on the mother board 8. Next, as shown in FIG. 9, the solder 2 covering the joining pin 1 is melted by heating the joining pin 1. Thus, the joining head portion 11 of the joining pin 1 and the opposite party pad 81 are joined to each other by the solder 2.

An operation and effects of this example will be explained next.

As shown in FIG. 1, in this example, the joining pin 1 is inserted into the through hole 60 in the printed wiring board 100. The joining pin 1 has the joining head portion 11 for joining the joining pin 1 to the opposite party pad 81. As a result, the through hole 60 and the opposite party pad 81 can be connected to each other electrically by the joining pin 1 from joining the joining head portion 11 to the opposite party pad 81.

Further, since the through hole 60 and the opposite party pad 81 can be connected to each other by the joining pin 1 in a facing state, it is unnecessary to arrange a pad for mounting a soldering ball in addition to the through hole 60 as in the conventional case. It is also unnecessary to form a conductor circuit for connecting the through hole 60 and the pad for mounting the ball to each other as in the conventional case. Therefore, as shown in FIG. 10, a surplus space is formed on the surface of the circuit substrate 6 in a portion except for the opening portion of the through hole 60. Another conductor circuit 50 can be formed in this space so that a high density wiring structure can be realized.

In particular, in the printed wiring board 100 in this example, as shown in FIG. 9, the mounting portion 7 is opened on a side opposed to the mother board 8, i. e. , a proj ec t ing side of the joining pin 1. As shown in FIG. 10, many bonding pad portions 51 are arranged in the vicinity of an opening portion of the mounting portion 7. Accordingly, it is necessary to form many conductor circuits 50 to each other for connecting the bonding pad portions 51 and the through hole 60. Therefore, when many conductor circuits 50 are formed in the above surplus space on the surface of the circuit substrate 6 as in this example, the bonding pad portions 51 and the through hole 60 can be connected and wired at high density.

Accordingly, in the printed wiring board 100 of a face-down type as in this example, it is very significant to have a structure in which the joining pin 1 is inserted into the through hole 60 and is joined to the mother board 8 by the joining head portion 11 of the joining pin 1.

The joining pin 1 is manufactured by using a material unmelted at a heating temperature at which the joining pin 1 is soldered and joined to the opposite party pad 81. Therefore, a constant height of the joining head portion 11 is maintained in the soldering and joining without melting deformation. Accordingly, the joining head portion 11 functions as a strut of the printed wiring board at the soldering and joining times.

As shown in FIG. 2, such a joining head portion 11 functioning as a strut is greater than an opening diameter of the through hole 60. Therefore, when the leg portion 12 of the joining pin 1 is inserted into the through hole 60, the joining head portion 11 is engaged with the opening portion 601 of the through hole 60 and does not enter the interior of the through hole 60. Accordingly, the joining head portion 11 can be projected by the same height from the surface of the circuit substrate 6.

Therefore, as shown in FIG. 9, when the joining head portion 11 and the opposite party pad 81 is soldered and joined to each other, the distance between the mother board 8 and the printed wiring board 100 is secured constantly by the joining head port ion 11. Accordingly, the printed wiring board 100 can be joined to the mother board 8 arranged in a parallel state.

Since no joining pin 1 is melted and deformed at the heating temperature in the soldering and joining, it is not necessary to control a melting state of the solder for joining. Accordingly, the joining pin 1 and the opposite party pad 81 can be easily soldered and joined to each other.

Further, the leg portion 12 of the joining pin 1 is inserted into the through hole 60, and the leg portion 12 and the through hole 60 are joined to each other by the soldering material 20. Therefore, in the printed wiring board 100 in this example, it is possible to avoid a structure (see FIG. 29) for joining a soldering ball to a pad for mounting the ball as in the conventional example. Accordingly, there is no apprehension that an intermediate layer is formed between the soldering ball and the pad for mounting the ball. Hence, the joining pin 1 can be strongly fixed to the through hole 60.

As shown in FIG. 2, the end tip portion 121 of the leg portion 12 of the joining pin 1 is slightly greater than a diameter of the through hole 60. Therefore, the leg portion 12 is inserted into the through hole 60 while the leg portion 12 presses against a wall face of the through hole 60 and distorts this wall face. Accordingly, the joining pin 1 is fixed to the through hole 60 and does not fall off before solder fills the through hole 60. Further, a filling operation of the soldering material 20 can be performed easily.

### Example 2

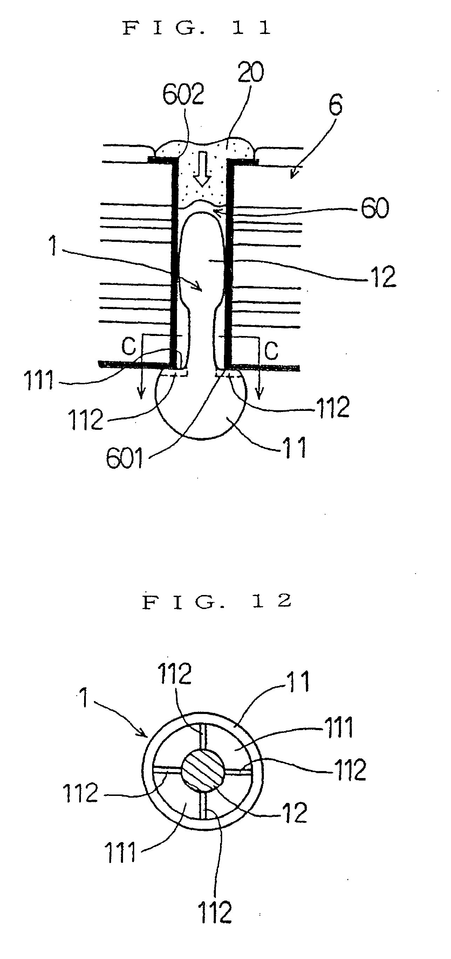

In this example, as shown in FIGS. 11 and 12, a groove 112 for extracting the air is formed in a lower portion 111 of the joining head portion 11 of the joining pin 1.

As shown in FIG. 12, four grooves 112 are formed in a radiating shape from a central portion of the lower portion 111 toward its exterior. Each of the grooves 112 has 0. 1 mm in width and 0.05 mm in depth.

A surface of the joining pin in this example is covered with unillustrated solder.

The other constructions are similar to those in the embodiment mode example 1.

In this example, as shown in FIG. 11, when a melted soldering material 20 is flowed into the through hole 60, the air existing within the through hole 60 is discharged outward through a portion between an opening portion 601 of the above through hole 60 and each of the grooves 112. Therefore, no air is sealed within the through hole 60. Accordingly, the entire interior of the through hole 60 can be filled with the soldering material 20 without any clearance.

Effects similar to those in example 1 can also be obtained in this example.

In this example, the interior of the through hole 60 is filled with the soldering material 20 from an opening portion 602 on a side opposed to an inserting direction of the joining pin 1. However, the interior of the through hole 60 can also be filled with the soldering material 20 from the opening portion 601 in a reverse direction, i. e., on the same side as the inserting direction of the joining pin 1. In this case, the interior of the through hole 60 filled with the soldering material 20 by a method for dipping the above circuit substrate into a melting solder reservoir.

### Example 3

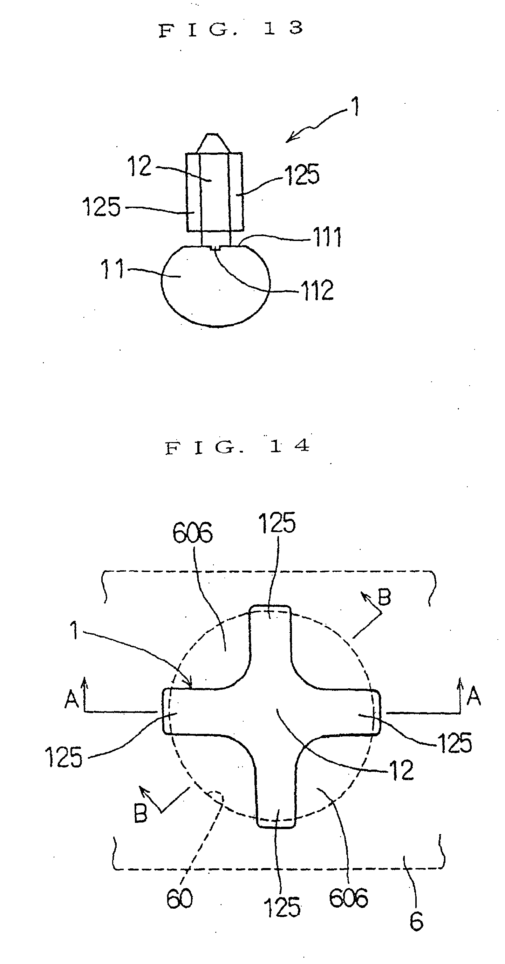

In this example, as shown in FIGS. 13 and 14, a leg port ion 12 of the joining pin 1 has plural projecting portions 125 widened in a radiating shape. Each of the projecting portions 125 has a maximum diameter of 0.35 mm slightly greater than a diameter of the through hole 60.

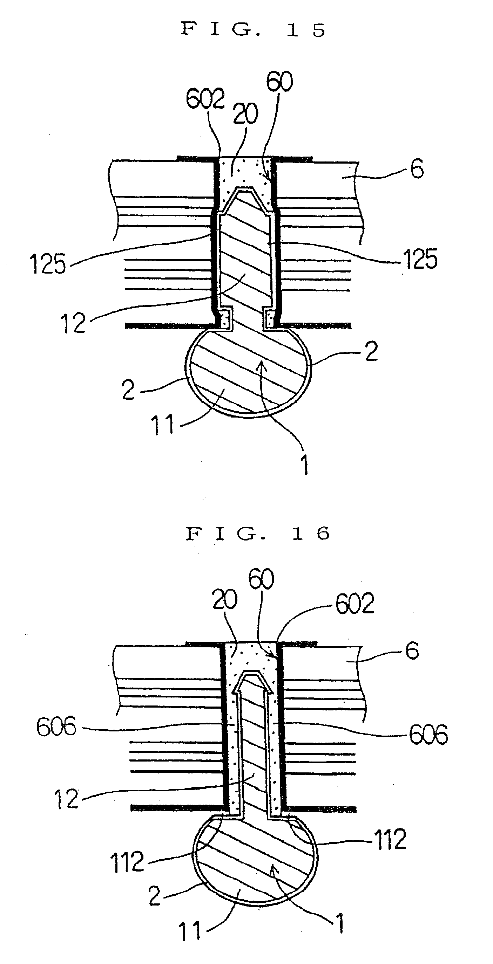

Similar to example 2, a groove 112 is formed in a joining head portion 11 of the joining pin 1. As shown in FIGS. 15 and 16, a surface of the joining pin 1 is covered with solder 2. The other constructions are similar to those in example 1.

In this example, as shown in FIGS. 13 and 14, the plural projecting portions 125 are formed in the leg portion 12 of the joining pin 1. Therefore, as shown in FIGS. 15 and 16, when each projecting portion 125 is inserted into the through hole 60, both ends of the projecting portion 125 are inserted into the through hole 60whileboth the ends of the projecting portion 125 locally press against a wall face of the through hole 60, since the projecting portion 125 is slightly greater than the diameter of the through hole 60. Therefore, it is possible to insert the joining pin 1 by small pressing force in comparison with the joining pin 1 in example 1 in which an entire inner wall of the through hole 60 is pressed.

Further, as shown in FIG. 16, after the joining pin 1 is inserted into the through hole 60, a melted soldering material 20 is flowed from an opening portion 602 on a side opposed to the inserting direction of the joining pin 1, and fills the interior of the through hole 60. At this time, as shown in FIGS. 14 and 16, the air existing within the through hole 60 is discharged outward through a clearance 606 between the through hole 60 and the leg portion 12 of the joining pin 1, and the groove 112. Therefore, the interior of the through hole 60 can be filled with the soldering material 20 without sealing the air.

### Example 4

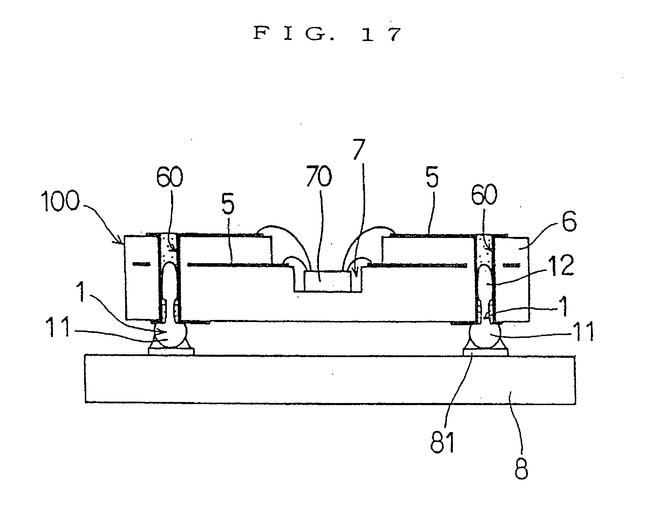

As shown in FIG. 17, in a printed wiring board in this example, a concave mounting portion 7 for mounting an electronic part 70 constitutes a substrate of a face-up type for mounting electronic parts and opened on a side opposed to a mother board 8. A joining head portion 11 of the joining pin 1 is projected from the through hole 60 on a side opposed to the mother board 8 in the circuit substrate 6. The other constructions are similar to those in example 1.

In this example, similar to example 1, surface high density wiring of the circuit substrate 6 can be performed and the printed wiring board can be joined to the mother board 8 in parallel with this mother board 8 and is superior in joining strength.

### Embodiments of the invention

### Embodiment 1

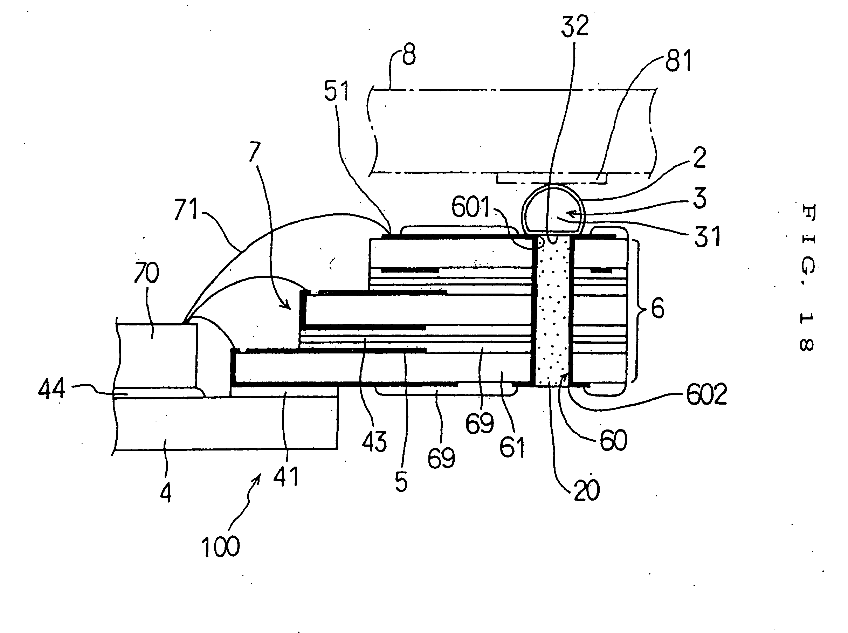

A printed wiring board in an embodiment of the present invention will be explained by using FIGS. 18 to 24.

As shown in FIG. 18, the printed wiring board 100 in this embodiment has a circuit substrate 6 having a conductor circuit 5 and a through hole 60, and a joining ball 3 joined to the through hole 60.

The joining ball 3 is manufactured by using a material unmelted at a heating temperature when the joining ball 3 is soldered and joined to an opposite party pad 81 on a mother board 8. For example, the joining ball 3 is manufactured by using covar, phosphor bronze, etc. The joining ball 3 is constructed by a joining head portion 31 and a bottom portion 32. The joining head portion 31 is greater than the diameter of an opening portion 601 of the through hole 60 and forms a joining portion to the opposite party pad 81. The bottom portion 32 is opposed to the opening portion 601 of the through hole 60. The bottom portion 32 is arranged in the opening portion 601 of the through hole 60 and is joined to the through hole 60 by a soldering material 20 filling the interior of the through hole 60.

The joining head portion 31 and the bottom portion 32 of the joining ball 3 are covered with solder 2 having 0.01 to 0. 015 mm in thickness.

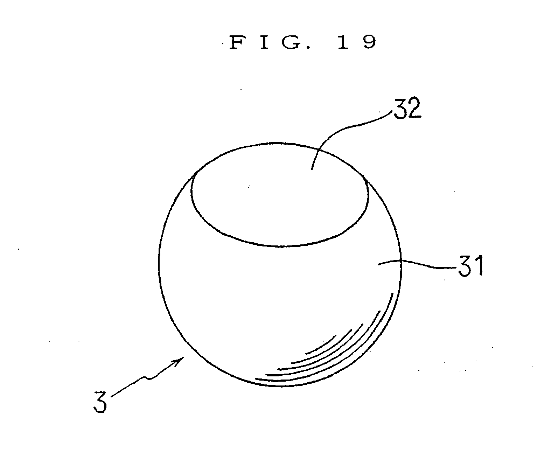

As shown in FIG. 19, the joining head portion 31 of the joining ball 3 is formed in the shape of a spherical body having 0.75 mm in diameter. The bottom portion 32 is formed in a flat face shape and a circular shape having 0.6 mm in diameter. The opening portion 601 of the through hole 60 has 0.32 mm in diameter.

In the printed wiring board 100 in this embodiment, the other structures of the above joining ball 3 are similar to those in example 1.

A manufacturing method of the above printed wiring board will be explained in detail next.

Similar to example 1, a multilayer circuit substrate 6 having a through hole 60 is formed first (see FIGS. 3 and 4).

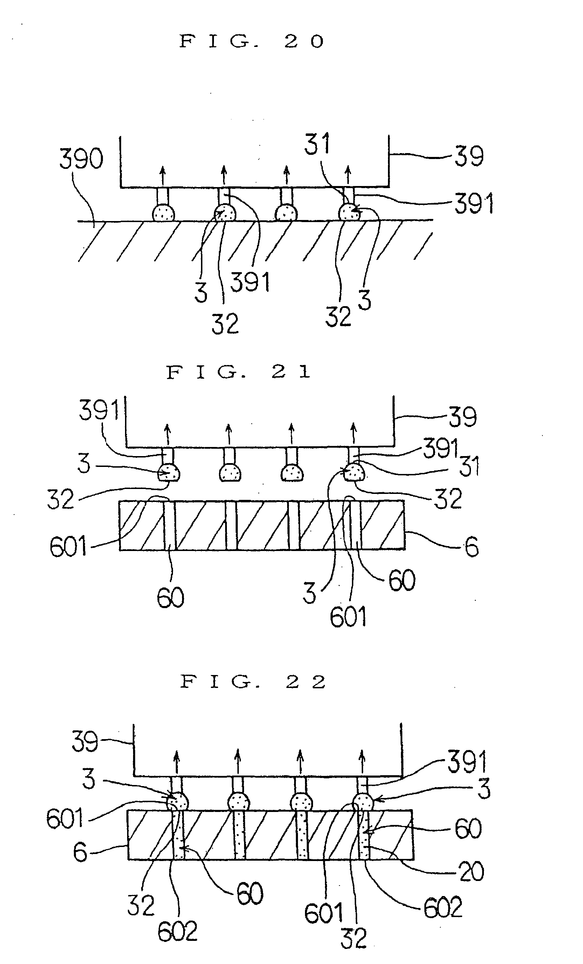

Next, as shown in FIG. 20, a joining ball 3 is arranged on a flat face base 390. At this time, a bottom portion 32 of the joining ball 3 is set to face the flat face base 390 by slightly vibrating the flat face base 390, and a joining head portion 31 is directed upward. Next, the joining head portion 31 of the joining ball 3 is absorbed and held by a sucking port 391 of a sucking device 39 by making the sucking port 391 approach the flat face base 390.

Next, as shown in FIG. 21, the sucking device 39 is moved above the above circuit substrate 6 while the sucking device 39 absorbs and holds the joining ball 3. Positions of the joining ball 3 and the through hole 60 are aligned with each other. Next, the sucking device 39 is set to approach the circuit substrate 6 and the joining ball 3 is arranged in the opening portion 601 of the through hole 60 which is arranged in the circuit substrate 6. At this time, since the joining head portion 31 of the joining ball 3 is absorbed and held in the sucking port 391, the bottom portion 32 of the joining ball 3 faces the opening portion 601.

Next, as shown in FIG. 22, the interior of the through hole 60 is filled with a soldering material 20 from an opening portion 602 on an unarranged side of the joining ball 3 in a fixing state of the sucking device 39 and the circuit substrate 6.

At this time, when the opening portion 601 is closed by the bottom portion 32 of the joining ball 3, it is difficult for the soldering material 20 to enter the through hole 60. Therefore, the interior of the through hole 60 is filled with the soldering material 20 by a method for dipping the circuit substrate into a soldering bath, a method for applying a supersonic wave to the soldering bath dipping the circuit substrate thereinto, etc.

Next, the soldering material 20 is cooled, solidified and congealed. Thus, the joining ball 3 is joined to the through hole 60 by the soldering material 20. Thereafter, the sucking port 391 is detached from the joining ball 3 by weakening the sucking force of the sucking device 39.

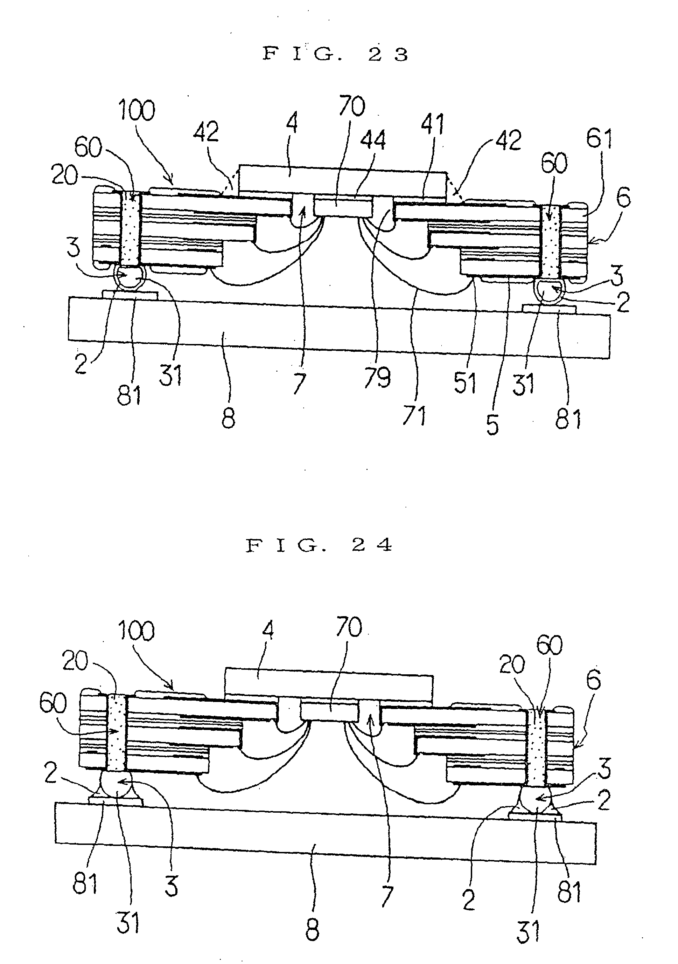

Next, as shown in FIG. 23, a heat radiating plate 4 is adhered to the circuit substrate 6 by an adhesive 41 constructed by epoxy resin. The heat radiating plate 4 is adhered to the circuit substrate 6 so as to cover an opening portion of a through hole 79 formed in an outermost resin substrate 61. After the adhesion using the adhesive 41, there is also a case in which a side face of the heat radiating plate 4 and a surface of the circuit substrate 6 are joined to each other by an adhesive 42 constructed by solder.

Thus, the above printed wiring board 100 is obtained.

As shown in FIG. 23, an electronic part 70 is adhered to a mounting portion 7 by an adhesive 44 in the above printed wiring board 100. The electronic part 70 and a bonding pad portion 51 of a conductor circuit 5 are electrically connected to each other by a bonding wire 71. The electronic part 70 and the bonding wire 71 are then sealed by resin.

Next, the joining ball 3 of the printed wiring board 100 is arranged on the surface of an opposite party pad 81 on a mother board 8. Next, as shown in FIG. 24, solder 2 covering the joining ball 3 is melted by heating this joining ball 3. Thus, the joining head portion 31 of the joining ball 3 and the opposite party pad 81 are joined to each other by the solder 2.

Next, an operation and effects of this embodiment will be explained.

In the printed wiring board 100 in this embodiment, as shown in FIG. 18, the joining ball 3 is joined to the through hole 60. The joining ball 3 has the joining head portion 31 for joining the joining ball 3 to the opposite party pad 81. Therefore, the through hole 60 and the opposite party pad 81 can be electrically connected to each other by the joining ball 3 by joining the joining head portion 31 to the opposite party pad 81.

The joining ball 3 is joined to the opening portion 601 of the through hole 60. Therefore, the through hole 60 and the opposite party pad 81 can be electrically connected to each other in a facing state. Accordingly, it is unnecessary to arrange a pad for mounting a soldering ball in addition to the through hole 60 as in the conventional case. It is also unnecessary to form a conductor circuit for connecting the through hole 60 and the pad for mounting the ball as in the conventional case. Therefore, a surplus space is formed on a surface of the circuit substrate 6 in a portion except for the through hole 60 (see FIG. 10). Another conductor circuit 50 can be formed in this space so that a high density wiring structure can be realized.

Similar to example 1, the printed wiring board 100 particularly in this example is of a face-down type as shown in FIG. 24. Therefore, a structure for fixedly joining the joining ball 3 to the through hole 60 and joining the printed wiring board 100 to the mother board 8 by the joining head portion 31 of the joining ball 3 is extremely significant to produce high density wiring between plural bonding pad portions 51 and the through hole 60.

The joining ball 3 is manufactured by using a material unmelted at a heating temperature when the joining ball 3 is soldered and joined to the opposite party pad 81. Therefore, a constant height of the joining ball 3 is maintained without melting deformation in the soldering and joining. Accordingly, the joining ball 3 functions as a strut of the printed wiring board 100 at the soldering and joining times.

Further, the joining head portion 31 of such a joining ball 3 is greater than the opening portion 601 of the through hole 60 functioning as a strut. Therefore, when the joining ball 3 is joined to the through hole 60, the joining head portion 31 is engaged with the opening portion 601 of the through hole 60 and does not enter the interior of the through hole 60. Accordingly, the joining head portion 31 can be projected by the same height from the surface of the circuit substrate 6.

Therefore, as shown in FIG. 24, when the joining head portion 31 and the opposite party pad 81 are soldered and joined to each other, the distance between the mother board 8 and the printed wiring board 100 is constantly secured by the joining head portion 31. Accordingly, the printed wiring board 100 can be joined to the mother board 8 in a parallel arranging state.

Furthermore, since no joining ball 3 is melted and deformed at the heating temperature in the soldering and joining, it is not necessary to control a melting state of the solder for joining. Accordingly, the joining ball 3 and the opposite party pad 81 can be easily soldered and joined to each other.

The bottom portion 32 of the joining ball 3 is joined to the opening portion 601 of the through hole 60 by the soldering material 20. There f ore, similar to example 1, there is no apprehension of an intermediate layer forming causing a reduction in joining strength. Accordingly, the joining ball 3 can be strongly fixed to the through hole 60. Embodiment 2

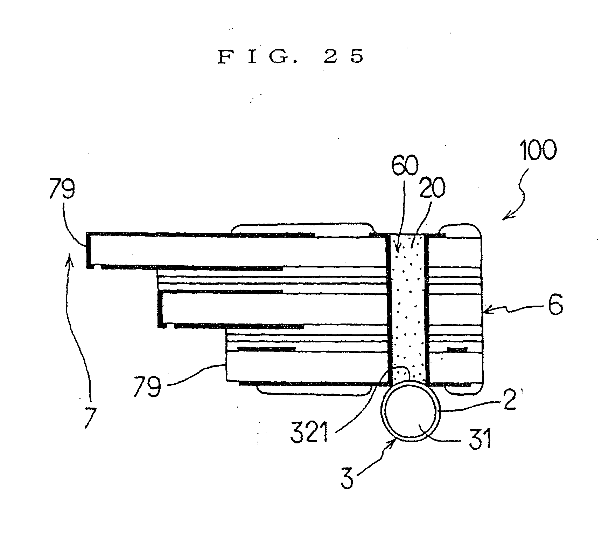

In this example, as shown in FIG. 25, a bottom portion 321 of the joining ball 3 constitutes one portion of a spherical surface.

Specifically, an entire shape of the joining ball 3 including the joining head portion 31 and the bottom portion 321 is formed as a spherical body which has a diameter of 0. 75 mm. Therefore, a joining area of an inner wall of the through hole 60 and a soldering material 20 is increased. Accordingly, the joining ball 3 is more reliably joined to the through hole 60. The other constructions are similar to those in the embodiment 1, and similar effects can be obtained to those in the embodiment 1

### Embodiment 3

As shown in FIG. 26, a printed wiring board 100 in this example is a substrate of a face-up type for mounting electronic parts in which a concave mounting portion 7 for mounting an electronic part 70 is opened on a side opposed to a mother board 8. A joining head portion 31 of the joining ball 3 is projected from the through hole 60 on a side opposed to the mother board 8 in the circuit substrate 6.

The other constructions are similar to those in the embodiment 1.

In this example, similar to the embodiment 1, high density wiring can be performed on a surface of the circuit substrate and the printed wiring board can be joined to the mother board parallel with the mother board which has a superior joining strength.

### Industrial applicability

As mentioned above, the present invention can provide a printed wiring board and its manufacturing method in which high density wiring can be performed on a substrate surface and the printed wiring board can be joined to a partner member in parallel with the partner member which has a superior joining strength.

## Claims

1. A printed wiring board (100) having a circuit substrate (6) having a conductor circuit (5) and a through hole (60), and a joining ball (3) joined to said through hole (60);
wherein, said joining ball (3) is constructed by a joining head portion (31) greater than an opening portion of said through hole (60), wherein said joining head portion forms a joining portion adapted for joining to an opposite party pad, and wherein a bottom portion (32) of said joining ball (3) facing the opening portion (601) of said through hole (60), is arranged in the opening portion of said through hole (60),
the printed wiring board (100) being **characterized in that** the joining head portion (31) of said joining ball (3) is covered with a conductive material and the joining ball (3) is manufactured by using a material unmelted at a heating temperature which melts the conductive material covering the joining head portion (31), and **in that** the bottom portion (32) is joined to the through hole (60) by a conductive material filling the interior of the through hole.

2. The printed wiring board as claimed in claim 1, wherein said material of the joining ball (3) is covar or phosphor bronze.

3. The printed wiring board as claimed in claim 1 or 2, wherein said joining head portion (31) is constructed by a spherical body.

4. The printed wiring board as claimed in any one of claims 1 to 3, wherein said conductive material is a soldering material.

5. The printed wiring board as claimed in any one of claims 1 to 3, wherein said conductive material is epoxy resin impregnated with a silver filler.

6. A manufacturing method of a printed wiring board (100) **characterized in that** the manufacturing method comprises:
a process for preparing a circuit substrate (6) having a conductor circuit (5) and a through hole (60);
a process for manufacturing a joining ball (3) with a bottom portion (32) and a joining head (31) portion greater than an opening portion of said through hole (60), wherein the joining head portion (31) of said joining ball (3) is covered with a conductive material in advance before the joining head portion (31) is arranged in the through hole (60), and the joining ball (3) is formed by a material unmelted at a heating temperature which melts the conductive material covering the joining head portion (31), said joining ball (3) forms a joining portion adapted for joining to an opposite party pad;
a process for arranging said joining ball (3) in a state in which said bottom portion (32) faces the opening portion of said through hole (60); and
a process for filling the interior of said through hole (60) with a conductive material and joining said through hole (60) and said bottom portion (32) to each other by the conductive material.

7. The manufacturing method as claimed in claim 6, wherein said material of the joining ball (3) is covar or phosphor bronze.

8. The manufacturing method of the printed wiring board as claimed in claim 6 or 7, wherein the process for arranging said joining ball (3), and the process for filling the interior of said through hole (60) with said conductive material are performed in a state in which the joining head portion (31) of said joining ball (3) is absorbed to a sucking port of a sucking device.

9. The manufacturing method of the printed wiring board as claimed in any one of claims 6 to 8, wherein said conductive material is a soldering material.

10. The manufacturing method of the printed wiring board as claimed in any one of claims 6 to 8, wherein said conductive material is epoxy resin impregnated with a silver filler.

## Patentansprüche

1. Leiterplatte (100), die ein Schaltkreissubstrat (6) mit einer Leiterschaltung (5) und einem Durchkontaktloch (60), und eine Verbindungskugel (3) aufweist, die mit dem Durchkontaktloch (60) verbunden ist;
wobei die Verbindungskugel (3) durch einen Verbindungskopfabschnitt (31) gebildet wird, der größer als ein Öffnungsabschnitt des Durchkontaktlochs (60) ist, wobei der Verbindungskopfabschnitt einen Verbindungsabschnitt bildet, der eingerichtet ist, sich mit einer Gegenbondinsel zu verbinden, und wobei ein unterer Abschnitt (32) der Verbindungskugel (3), der dem Öffnungsabschnitt (601) des Durchkontaktlochs (60) gegenüberliegt, im Öffnungsabschnitt des Durchkontaktlochs (60) angeordnet ist,
wobei die Leiterplatte (100) **dadurch gekennzeichnet ist, daß** der Verbindungskopfabschnitt (31) der Verbindungskugel (3) mit einem leitfähigen Material überzogen ist und die Verbindungskugel (3) unter Verwendung eines Materials hergestellt ist, das bei einer Erhitzungstemperatur nicht geschmolzen wird, die das leitfähige Material schmilzt, das den Verbindungskopfabschnitt (31) überzieht, und daß der untere Abschnitt (32) durch ein leitfähiges Material, das das Innere des Durchkontaktlochs füllt, mit dem Durchkontaktloch (60) verbunden ist.

2. Leiterplatte nach Anspruch 1, wobei das Material der Verbindungskugel (3) Kovar oder Phosphorbronze ist.

3. Leiterplatte nach Anspruch 1 oder 2, wobei der Verbindungskopfabschnitt (31) durch einen kugelförmigen Körper gebildet wird.

4. Leiterplatte nach einem der Ansprüche 1 bis 3, wobei das leitfähige Material ein Lötmaterial ist.

5. Leiterplatte nach einem der Ansprüche 1 bis 3, wobei das leitfähige Material Epoxidharz ist, das mit einem Silberfüllstoff imprägniert ist.

6. Herstellungsverfahren für eine Leiterplatte (100), **dadurch gekennzeichnet, daß** das Herstellungsverfahren aufweist:
einen Prozeß zur Vorbereitung eines Schaltkreissubstrats (6), das eine Leiterschaltung (5) und ein Durchkontaktloch (60) aufweist;
einen Prozeß zur Herstellung einer Verbindungskugel (3) mit einem unteren Abschnitt (32) und einem Verbindungskopfabschnitt (31), der größer als ein Öffnungsabschnitt des Durchkontaktlochs (60) ist, wobei der Verbindungskopfabschnitt (31) der Verbindungskugel (3) im voraus mit einem leitfähigen Material überzogen wird, bevor der Verbindungskopfabschnitt (31) im Durchkontaktloch (60) angeordnet wird, und die Verbindungskugel (3) durch ein Material gebildet wird, das bei einer Erhitzungstemperatur nicht geschmolzen wird, die das leitfähige Material schmilzt, das den Verbindungskopfabschnitt (31) überzieht, wobei die Verbindungskugel (3) einen Verbindungsabschnitt bildet, der zum Verbinden mit einer Gegenbondinsel eingerichtet ist;
einen Prozeß zum Anordnen der Verbindungskugel (3) in einem Zustand, in dem der untere Abschnitt (32) dem Öffnungsabschnitt des Durchkontaktlochs (60) gegenüberliegt; und
einen Prozeß zum Füllen des Inneren des Durchkontaktlochs (60) mit einem leitfähigen Material und Verbinden des Durchkontaktlochs (60) und des unteren Abschnitt (32) miteinander durch das leitfähige Material.

7. Herstellungsverfahren nach Anspruch 6, wobei das Material der Verbindungskugel (3) Kovar oder Phosphorbronze ist.

8. Herstellungsverfahren der Leiterplatte nach Anspruch 6 oder 7, wobei der Prozeß zum Anordnen der Verbindungskugel (3), und der Prozeß zum Füllen des Inneren des Durchkontaktlochs (60) mit dem leitfähigen Material in einem Zustand durchgeführt werden, in dem der Verbindungskopfabschnitt (31) der Verbindungskugel (3) in eine Ansaugöffnung einer Saugvorrichtung aufgenommen ist.

9. Herstellungsverfahren der Leiterplatte nach einem der Ansprüche 6 bis 8, wobei das leitfähige Material ein Lötmaterial ist.

10. Herstellungsverfahren der Leiterplatte nach einem der Ansprüche 6 bis 8, wobei das leitfähige Material Epoxidharz ist, das mit einem Silberfüllstoff imprägniert ist.

## Revendications

1. Carte de câblage imprimée (100) ayant un substrat de circuit (6) avec un circuit conducteur (5) et un trou d'insertion (60), et une bille de connexion (3) raccordée au trou d'insertion (60) ;
la bille de connexion (3) étant construite par une partie de tête de raccordement (31) plus grande qu'une partie d'ouverture du trou d'insertion (60), la partie de tête de raccordement formant une partie de raccordement prévue pour raccorder une pastille opposée, et une partie de fond (32) de la bille de connexion (3) opposée à la partie d'ouverture (601) du trou d'insertion (60) étant disposée dans la partie d'ouverture du trou d'insertion (60),
la carte de câblage imprimée (100) étant **caractérisée en ce que** la partie de tête de raccordement (31) de la bille de connexion (3) est revêtue d'un matériau conducteur et la bille de connexion (3) est fabriquée en utilisant un matériau n'étant pas fondu à une température de chauffage faisant entrer en fusion le matériau conducteur revêtant la partie de tête de raccordement (31), et **en ce que** la partie de fond (32) est raccordée au trou d'insertion (60) par un matériau conducteur comblant l'intérieur du trou d'insertion.

2. Carte de câblage imprimée selon la revendication 1, où le matériau de la bille de connexion (3) est du Kovar ou du phosphore bronze.

3. Carte de câblage imprimée selon la revendication 1 ou 2, où la partie de tête de raccordement (31) est construite par un corps sphérique.

4. Carte de câblage imprimée selon l'une quelconque des revendications 1 à 3, où le matériau conducteur est un matériau de soudure.

5. Carte de câblage imprimée selon l'une quelconque des revendications 1 à 3, où le matériau conducteur est de la résine époxy imprégnée avec une charge d'argent.

6. Procédé de fabrication d'une carte de câblage imprimée (100), **caractérisé en ce** ledit procédé de fabrication comprend :
un process pour préparer un substrat de circuit (6) avec un circuit conducteur (5) et un trou d'insertion (60) ;
un process pour fabriquer une bille de connexion (3) avec une partie de fond (32) et une partie de tête de raccordement (31) plus grande qu'une partie d'ouverture du trou d'insertion (60), la partie de tête de raccordement (31) de la bille de connexion (3) étant revêtue d'un matériau conducteur antérieurement à la disposition de la partie de tête de raccordement (31) dans le trou d'insertion (60), et la bille de connexion (3) étant formée par un matériau n'étant pas fondu à une température de chauffage faisant entrer en fusion le matériau conducteur revêtant la partie de tête de raccordement (31), la bille de connexion (3) formant une partie de raccordement prévue pour raccorder une pastille opposée ;
un process pour disposer la bille de connexion (3) dans un état où la partie de fond (32) est opposée à la partie d'ouverture du trou d'insertion (60) ; et
un process pour combler l'intérieur du trou d'insertion (60) avec un matériau conducteur et raccorder l'un à l'autre le trou d'insertion (60) et la partie de fond (32) par le matériau conducteur.

7. Procédé de fabrication selon la revendication 6, où le matériau de la bille de connexion (3) est du Kovar ou du phosphore bronze.

8. Procédé de fabrication de la carte de câblage imprimée selon la revendication 6 ou 7, où le process pour disposer la bille de connexion (3) et le process pour combler l'intérieur du trou d'insertion (60) avec le matériau conducteur sont exécutés dans un état où la partie de tête de raccordement (31) de la bille de connexion (3) est absorbée par un port de succion d'un dispositif de succion.

9. Procédé de fabrication de la carte de câblage imprimée selon l'une quelconque des revendications 6 à 8, où le matériau conducteur est un matériau de soudure.

10. Procédé de fabrication de la carte de câblage imprimée selon l'une quelconque des revendications 6 à 8, où le matériau conducteur est de la résine époxy imprégnée avec une charge d'argent.
